# EUROPEAN PATENT SPECIFICATION

(11) **EP 2 577 727 B1**
(45) Date of publication and mention of the grant of the patent: **16.03.2016**
(21) Application number: 11860699.5
(22) Date of filing: 02.09.2011
(51) Int. Cl.: H01L 21/60, H01L 23/544, H01L 23/552, H01L 21/56

(54) **METHOD FOR FORMING COLOR IMAGES ON MEMORY DEVICES**
VERFAHREN ZUR HERSTELLUNG VON FARBBILDERN AUF SPEICHERVORRICHTUNGEN
PROCÉDÉ DE FORMATION D'IMAGES EN COULEUR SUR DES DISPOSITIFS DE MÉMOIRE

(43) Date of publication of application: 10.04.2013
(73) Proprietor: SanDisk Semiconductor (Shanghai) Co., Ltd., Shanghai 200241 (CN); SanDisk Information Technology (Shanghai) Co., Ltd, Minhang District Shanghai 200241 (CN)
(72) Inventor: FU, Peng, Kunshan Jiangsu 215300 (CN); LU, Zhong, Shanghai 200127 (CN); CHIU, Chin-Tien, Taichung City 40767 (TW); YU, Cheeman, Fremont California 94538 (US); CHEN, Matthew, Shanghai 200241 (CN); JIANG, Weiting, Shanghai 200240 (CN)
(74) Representative: Tothill, John Paul
(86) International application number: PCT/CN2011/079283
(87) International publication number: WO 2013/029273

(56) References cited:
- CN-A- 101 488 492
- CN-A- 102 054 657
- JP-A- S6 074 654
- JP-A- S6 119 150
- US-A1- 2002 052 056
- US-A1- 2006 169 490
- US-A1- 2008 006 927
- US-B2- 7 651 958
- HIDEAKI MATSUTANI: "Compression molding solutions for various high end package and cost savings for standard package applications", EUROPEAN MICROELECTRONICS AND PACKAGING CONFERENCE. PROCEEDINGSOF IMAPS, XX, XX, 15 June 2009 (2009-06-15), pages 1-4, XP031534294, ISBN: 978-1-4244-4722-0
- HOTTA Y ET AL: "Foil covered PACkage (FPAC): a new package concept", ELECTRONIC COMPONENTS AND TECHNOLOGY CONFERENCE, 1996. PROCEEDINGS., 4 6TH ORLANDO, FL, USA 28-31 MAY 1996, NEW YORK, NY, USA,IEEE, US, 28 May 1996 (1996-05-28), pages 1258-1264, XP010167184, DOI: 10.1109/ECTC.1996.550896 ISBN: 978-0-7803-3286-7

## Description

### BACKGROUND OF THE INVENTION

### Field

The present technology relates to fabrication of semiconductor devices.

### Description of Related Art

The strong growth in demand for portable consumer electronics is driving the need for high-capacity storage devices. Non-volatile semiconductor memory devices, such as flash memory storage cards, are becoming widely used to meet the ever-growing demands on digital information storage and exchange. Their portability, versatility and rugged design, along with their high reliability and large capacity, have made such memory devices ideal for use in a wide variety of electronic devices, including for example digital cameras, digital music players, video game consoles, PDAs and cellular telephones.

Many memory devices, such as memory cards, have indicia on them to indicate the manufacturer of the memory device and its internal characteristics, such as its storage capacity. For some memory devices, such as some SD cards, the indicia is printed on a label, which is applied to the card during the manufacturing process. However, for other memory devices, such as some microSD cards, the presence of a label can result in an unacceptable overall card thickness. For such cards, the indicia is printed directly onto the device during the manufacturing process.

As one example of a process for fabricating cards with printed indicia, the cards are assembled with memory die and controller die mounted to a substrate, and then encapsulated in molding compound. Typically, the cards are batch processed a number at a time on a panel or strip for economies of scale. After encapsulation, the indicia can be printed onto the cards as a group using a pad printing process. In this process, the indicia for each of the cards is placed on a printing plate. The indicia is then transferred from the printing plate onto a silicone pad, and the silicone pad is pressed against the strip of memory cards. The memory cards are later separated from the strip.

In addition to or instead of current markings on a memory card, next generation memory cards are going to include a much greater wealth of information, in richer and more colourful text and images. Processes are in development to directly apply print and images onto memory cards via inkjet printing. As with pad printing, inkjet printing adds thickness to the memory card. Moreover, known inkjet print methods require one or more separate pre-processing steps to prepare the card to receive an inkjet image. If these pre-processing steps are not performed, it has been found that the inkjet image does not adhere well to the memory card surface.

US 2002/0052056 describes a method for embedding markings in the encapsulation of a semi-conductor device by transferring said markings from a transfer sheet to the encapsulation in a molding step.

According to the present invention, there is provided a method of providing graphical content on a memory device according to claim 1.

### DESCRIPTION OF THE DRAWINGS

FIGURE 1 is a flowchart of an embodiment of the present invention.
FIGURE 2 is an edge view of a release media according to an embodiment of the present invention.
FIGURE 3 is a schematic representation of a print head applying graphical content to a release media according to an embodiment of the present invention.
FIGURE 4 is illustrates graphical content printed on a release media according to an embodiment of the present invention.
FIGURE 5 is a panel of memory devices, prior to encapsulation, according to an embodiment of the present disclosure.
FIGURE 6 is an edge view of a panel of memory devices on an upper mold plate and a release media on a lower mold plate prior to encapsulating the memory devices.
FIGURE 7 is an edge view as in Fig. 6, further including molding compound in the lower mold plate.
FIGURE 8 illustrates the edge view of the mold plates and molding compound of Fig 7, with the memory devices immersed in the molding compound.
FIGURE 9 is an edge view of the upper and lower mold plates and the memory devices in the molding compound after curing of the molding compound.
FIGURE 10 is a top view of the encapsulated memory devices with graphical content being transferred from the release media onto the molding compound.
FIGURE 11 is a singulated memory device including graphical content according to an embodiment of the present invention.
FIGURE 12 is a cross-section through line 12-12 of Fig. 11.
FIGURE 13 is a view similar to Fig. 12 illustrating a further embodiment of the present invention.
FIGURES 14 and 15 illustrate an alternative embodiment where the graphical content formed on a group of memory devices includes different images.

### DETAILED DESCRIPTION

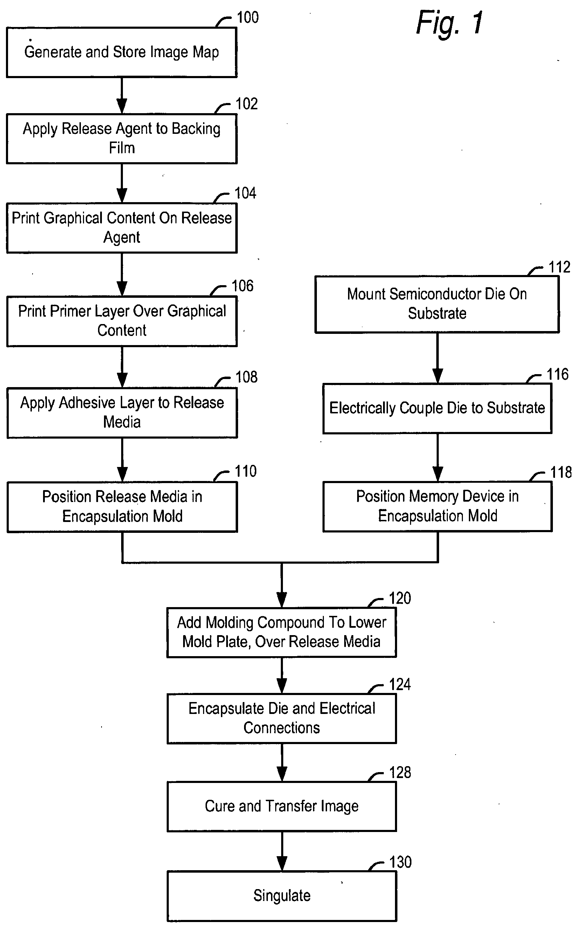

Embodiments will now be described with reference to Figs. 1 through 15, which relate to a method of applying graphical content to a memory device and a memory device formed thereby. It is understood that the present invention may be embodied in many different forms and should not be construed as being limited to the embodiments set forth herein. Rather, these embodiments are provided so that this disclosure will be thorough and complete and will fully convey the invention to those skilled in the art. Indeed, the invention is intended to cover alternatives, modifications and equivalents of these embodiments, which are included within the scope of the invention as defined by the appended claims. Furthermore, in the following detailed description of the present invention, numerous specific details are set forth in order to provide a thorough understanding of the present invention. However, it will be clear to those of ordinary skill in the art that the present invention may be practiced without such specific details.

The terms "top," "bottom," "upper," "lower," "vertical" and/or "horizontal" as may be used herein are for convenience and illustrative purposes only, and are not meant to limit the description of the invention inasmuch as the referenced item can be exchanged in position.

Fig. 1 is a flowchart of an embodiment for forming a memory device including graphical content on its front and/or back surface. The process in general includes a first set of steps for forming a release media including graphical content, a second set of steps for fabricating a memory device, and a third set of steps for encapsulating the memory device in molding compound while applying the graphical content from the release media to a surface of the molding compound. Each of these sets of steps is described below.

In step 100, an image map may be generated and stored. As explained below, images may be batch transferred onto a panel of substrates to achieve efficiency of scale. An image map may be created and stored in a system controller which maps what images are to be provided on which memory devices on the panel. It may be that all memory devices on a panel have the same image, or that different memory devices on a panel have different images. The image map may also store the images that are to be provided on multiple panels in a group of panels. It may be that all panels in the group have the same images, or that different panels and memory devices in the group have different images.

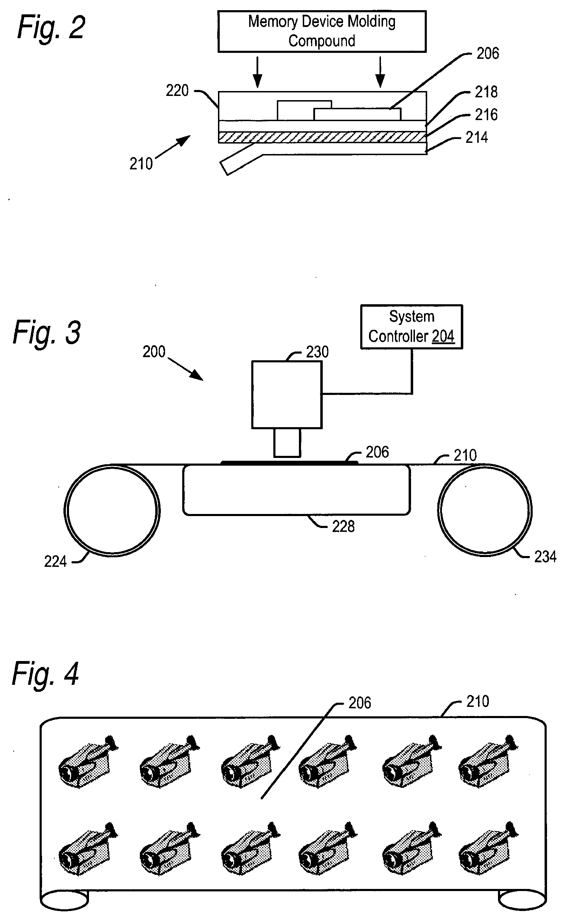

A system controller 204 (shown schematically in Fig. 3) is provided for storing the image map and designating which images are provided on which memory devices. The system controller 204 may take any suitable form, such as, but not limited to, a general purpose computer running image processing software and a hardware implementation including logic gates, switches, an application specific integrated circuit (ASIC), a programmable logic controller, and an embedded micro controller, for example. Accordingly, a computer-readable medium having stored therein computer-readable program code that implements some or all of the acts described herein and in the drawings can be used. The system controller 204 can be a single component or can be distributed over several components.

Steps 102 through 108 describe one process for forming release media 210. The release media 210 may be a variety of media capable of transferring an image onto another substrate (such as a molding compound of a memory device). Examples of release media 210 may include heat transfer foil, IMR (in mold roller) foil and those including an ETFE (ethylene tetrafluoroethylene) backing film, such as for example that marketed under the brand name Fluon® from Asahi Glass Co., Ltd., having a place of business in Tokyo, Japan. Other release media are contemplated.

Release media 210 has several layers. One example of a release media 210 is shown in more detail in the edge view of Fig. 2. The release media 210 in Fig. 2 may for example be a heat transfer foil or IMR foil. The media 210 includes a backing film 214, which may for example be a PET (polyethylene terephthalate) film. Other backing films are contemplated.

In step 102, a release agent 216 is applied onto the backing film 214. The release agent 216 may be a known compound such as for example the release agent ZY-01 from Dongguan Yimeiduo Transfer Material Co.,Ltd. in China, and may be applied in various processes, such as for example by a gravure press or coaters. The release agent 216 is a solid at room temperature with adhesive properties so as to adhere with the backing film 214. However, upon heating the release media 210, the release agent 216 may melt and separate from the backing film 214 as explained below.

A durable, hard-coated layer 218 is formed over the release agent 216. In step 104 one or more layers of graphical content 206 is applied to the durable layer 218 in accordance with the stored image map. The durable layer 218 provides a buffer between the release agent 216 and graphical content 206, and provides a more rigid surface on which to apply the graphical content 206.

A schematic representation of a printer 200 applying graphical content 206 to a roll of release media 210 is shown in Fig. 3. In one example, the graphical content 206 may be applied by a flatbed ink jet printer, such as for example a UJF-706 UV inkjet printer from Mimaki Engineering Co., Ltd. having a place of business in Nagano, Japan. The UJF-706 flatbed UV inkjet printer uses small, six picoliter droplets of UV-curable ink, which produces smooth tonal images, a variable dot size, and high 1,200 x 2,400 dpi resolution. Additionally, the UJF-706 flatbed UV inkjet printer is capable of printing eight colors, including white. As explained below, the ink is transferred from the release media to the memory package at high temperatures. Thus, in embodiments, temperature-resistant inks may be used. It is understood that the graphical content 206 may be applied to the release media 210 by other ink jet printers, and by a wide variety of other technologies, in further embodiments. Two such additional technologies are gravure printing and screen printing. In examples, the graphical content 206 may be applied in a single layer or in multiple layers.

The printable surface on memory devices, such as microSD cards, is typically black plastic. Providing graphical content onto a black surface may result in a faded looking image. Accordingly, in one embodiment, after printing the graphical images onto the release media in step 104, a primer layer can be printed over the graphical images in step 106. As explained below, when the graphical content including the images and primer layer is transferred onto a memory device, the primer layer will be transferred directly onto the memory device and the graphical images will be over the primer layer (so that the primer layer is sandwiched between the memory device and graphical images). The primer layer may be white, any suitable shade of white (e.g., off white), or other colors in further embodiments. Step 106 may be omitted in alternative embodiments.

In still further embodiments, a metallic layer, such as for example an aluminum layer, may be deposited onto the release media instead of or in addition to the graphical content 206. In such embodiments, the metallic layer may be deposited for example in a known vacuum vaporization process where the aluminum is vaporized in a vacuum chamber and deposited on the release media 210.

In step 108, an adhesive layer 220 is applied onto the hard-coated layer 218, over the graphical content 206 (i.e., over the primer layer, or other graphical content where the primer layer is omitted). The adhesive layer may for example be adhesive agent XT-088PP from Dongguan Yimeiduo Transfer Material Co., Ltd. in China, and may be applied in various processes, such as for example by a gravure press or coaters. The adhesive layer 220 is capable of cross-linking and adhering to a surface of a molding compound upon being cured as described below.

In an example where the release media 210 is a heat transfer foil, the total thickness of the media may be approximately 30 to 32 micron (µm). An example using IMR foil may be slightly thicker, at about 50 to 100 µm. The thicknesses of the release media 210 using these foils may each be thicker or thinner than the above ranges in further embodiments. In these examples, the graphical content may have a thickness of about 10 to 12 µm, though again, the thickness of the graphical content may be thicker or thinner than this in further embodiments.

Referring to Figs. 3 and 4, in embodiments, during the printing process, the release media may move from a supply roll 224 and into the printer 200. The printer 200 is schematically shown as having a support surface 228 and a print head 230, though examples of the printer 200 may include many more components. A take-up roll 234 is provided to receive portions of the release media 210 after they have been printed.

Fig. 4 shows graphical content 206 printed on release media 210. The figures in general use the example of the image of one or more cameras as graphical content 206 (perhaps to identify cards on which pictures and video are stored).However, graphical content 206 may refer to any indicia that can be printed onto release media 210 and then transferred onto a memory device as explained below. Examples of graphical content include, but are not limited to, pictures, photographs, decorative designs, logos, colors, symbols, text, and any combination thereof. It should be noted that graphical content can include text only and does not necessarily need to include a picture. Graphical content can convey information about an internal characteristic or property of the memory device, such as its storage capacity (e.g., 1 GB, 16 GB, etc.). The graphical content may reveal information relating to the type of content stored on the memory device, such as for example a picture of a musical note, to indicate the memory device is storing music, or a picture of a camera to indicate the memory device is storing pictures. The graphical content may alternatively be decorative, having no relation to the type of device or content, but provided so as to appeal to a certain segment of the market. The graphical content may simply be an area of solid color, such as for example white, gray, black or any other color.

The graphical content may be other indicia in further examples. Additional examples of the types of graphical content which may be provided on a surface of a memory device are set forth in U.S. Patent Application No. 2011/090277, entitled "Method and System for Printing Graphical Content onto a plurality of Memory Devices and for Providing a Visually Distinguishable Memory Device, filed October 4, 2010. As used herein, graphical content may refer to a single image (e.g., a single camera shown in the figures) or a group of images (i.e., a plurality of cameras shown in the figures).

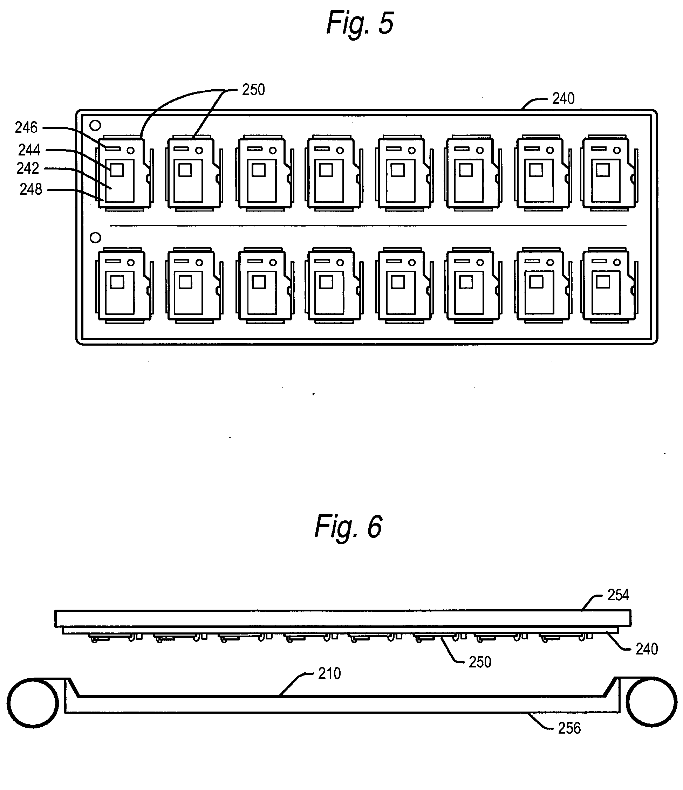

Referring again to the flowchart of Fig. 1, a memory device may be formed in steps 112 and 116. Fig. 5 shows a panel 240 for batch processing a number of memory devices 250 at the same time. Fig. 5 shows the memory devices 250 prior to encapsulation. Each memory device 250 may be formed with various electronic components such as one or more memory die 242, a controller die 244 and passive components 246 (numbered on one memory device 250 in Fig. 5) physically and electrically coupled to a substrate 248.

The panel 240 may for example be a printed circuit board, leadframe or tape automated bonding (TAB) tape. The number of rows and columns of individual memory devices 250 formed on the panel 240 are shown by way of example only, and the number of rows and/or columns may be greater or lesser than shown in further examples of panels 240.

While the example of Fig. 5 includes one or more memory die 242 and a controller die 244, the number and type of semiconductor die are not critical to the present disclosure and may vary in different embodiments. A device 250 may include a single semiconductor die, or it may contain for example eight or more memory die 242 together with a controller die 244. In embodiments, the memory device 250 further includes passive components 246, which may for example be resistors, capacitors, inductors and/or other electrical components. As explained below, one advantage of printing graphical content according to the present disclosure is that it does not add height to the thickness of a memory device 250. This may free up valuable space in the thickness of a memory device 250 for the provision of semiconductor die and electrical connections such as wire bonds, explained below.

In step 116, the die 242, 244 may be electrically bonded to each other and/or the substrate 248. In one example, step 116 may comprise a known wire bonding process forming wire bonds between the die and substrate. In a further example, step 116 may additionally or alternatively include a known flip chip bonding process to electrically couple one or more die to the substrate.

In the example of the release media 210 shown in Fig. 3, the graphical content 206 includes two rows of images across a width of the release media. It is understood that this is by way of example only, and there may be a single row or more than two rows of images across a width of the release media 210 in further embodiments. The spacing of the images of the graphical content along both rows and columns of the release media 210 is provided to match the spacing of the memory devices 250 in the rows and columns of the substrate panel 240. Thus, upon transfer of the graphical content 206 to the memory devices 250 as explained below, each memory device 250 may receive an image from the graphical content 206 on release media 210.

In embodiments, the number of images across the width of the release media 210 may correspond to the number of memory devices in a row or column of substrate panel 240. It is understood that the number of images across the width of the release media need not correspond to the number of memory devices in a row or column of a substrate panel 240 in further examples.

Fig. 3 also shows a roll of release media 210 having a length longer than the length of substrate panel 240. Thus, a single roll of release media 210 may provide graphical content for several substrate panels 240. However, in further embodiments, the release media may be formed with a shorter length in further embodiments. In one such embodiment, the release media 210 may have a length and width so that the number of images on a single piece of release media 210 matches the number of memory devices on one panel 240. In general, the length and width of the release media 210 may be provided so that the images in a row and/or column of media 210 are the same as, greater than or less than the number of memory devices 250 in a corresponding row or column of a substrate panel 240.

The steps 100, 104 and 106 in forming the release media with graphical content, and the steps 112 and 116 in forming the panel of memory devices, may be performed in parallel with each other, or one process may occur before the other. In any event, once the release media 210 and panel 240 of memory devices 250 have been fabricated, they may be placed within encapsulation mold plates in steps 110 and 118, respectively. One such example is shown in the edge view of Fig. 6. The substrate panel 240 may be mounted to a top mold plate 254 and a bottom mold plate 256 may be lined with the release media 210.

The top mold plate 254 may for example be a vacuum chuck for holding the substrate panel thereon against the forces of gravity. The substrate panel 240 may be held on the top mold plate 254 by other fastening mechanisms in further embodiments. In the example shown, the release media 210 is longer than the mold plates 254, 256 so as to extend beyond the ends of bottom mold plate 256. The film may be pulled down against the bottom mold plate 256 by a negative pressure applied to the surface of the mold plate. As noted above, the release media may be cut to a size so as to fit within the four edges of the lower mold plate 256. In the embodiments shown, the release media 210 is oriented left and right from the perspective of the drawings. However, it is understood that the release media may be provided within the lower mold plate 256 rotated 90° from that shown in the figures (i.e., into and out of the page) without changing the orientation of the panel 240.

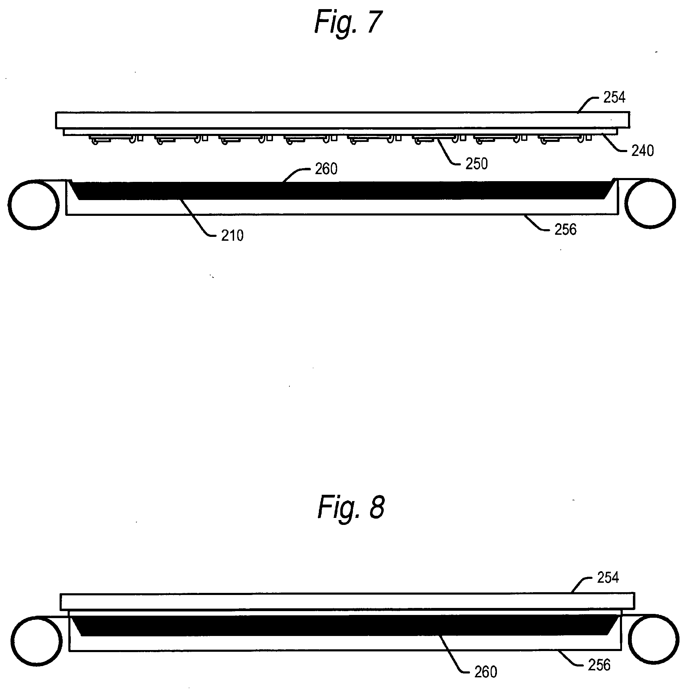

In step 120 and as shown in Fig. 7, molding compound 260 may be added into the lower mold plate 256, over the release media 210. In embodiments, the molding compound may be applied as a powder or as granules at room temperature. It may be applied onto the release media 210, and then the release media and molding compound may be moved onto the lower mold plate 256. In a further example, the release media 210 may be positioned on the lower mold plate 256, and then the molding compound 260 applied. The mold compound 260 may be a commercially available resin, for example sold by Kyocera Chemical Corporation, having a place of business in Saitama, Japan under model number KE-G1250AH-W3E.

Using mold compound 260, the memory package 250 may be encapsulated in step 124. The encapsulation process is performed by FFT (Flow Free Thin) compression molding. Such an FFT compression molding process is known and described for example in a publication by Matsutani, H. of Towa Corporation, Kyoto, Japan, entitled "Compression Molding Solutions For Various High End Package And Cost Savings For Standard Package Applications," Microelectronics and Packaging Conference, 2009. In general, an FFT compression machine makes use of a technique where the panel of substrates is immersed in a mold containing a molten resin. The resin fills all voids on the panel and encapsulates each memory device together in the molding compound on the panel of substrates, without exerting pressure on the die or bond wires. One specific type of FFT compression which may be used is PMC (pure malt compression) molding. Other types of FFT compression techniques and transfer molding techniques may be used in further embodiments.

In step 124, the top and bottom mold plates 256, 256 are slowly brought together under vacuum or near vacuum conditions, as shown by the transition from Fig. 7 to Fig. 8. The molding compound 260 may be heated to approximately 175°C at the time the memory devices 250 are dipped into the molding compound. At that temperature, the molding compound 260 may be in a liquid phase having a viscosity of approximately 16.2 Pa·s. It is understood that both the temperature and viscosity may vary above and below these values in further embodiments.

The mold plates may compress the substrate panel 240 against the lower mold plate 256 as shown in Fig. 8 at a temperature of 175°C for a period of about 13 to 15 seconds. Thereafter, a cure and image transfer step 128 may be performed. As indicated, this step performs two functions. First, step 128 melts the molding compound into a liquid and then cures the molding compound into a solid, protective layer around the electronic components and wire bonds of each memory device 250 on panel 240. Second, step 128 cross links the adhesive layer 220 of the release media 210 to the adjacent surface of the molding compound 260, while melting the release agent 216, to affix and transfer the adhesive layer 220, graphical content 206 and hard-coated layer 218 of release media 210 onto the molding compound 260. The backing film 214 remains on the bottom mold plate 256 by the negative pressure applied to the bottom mold plate.

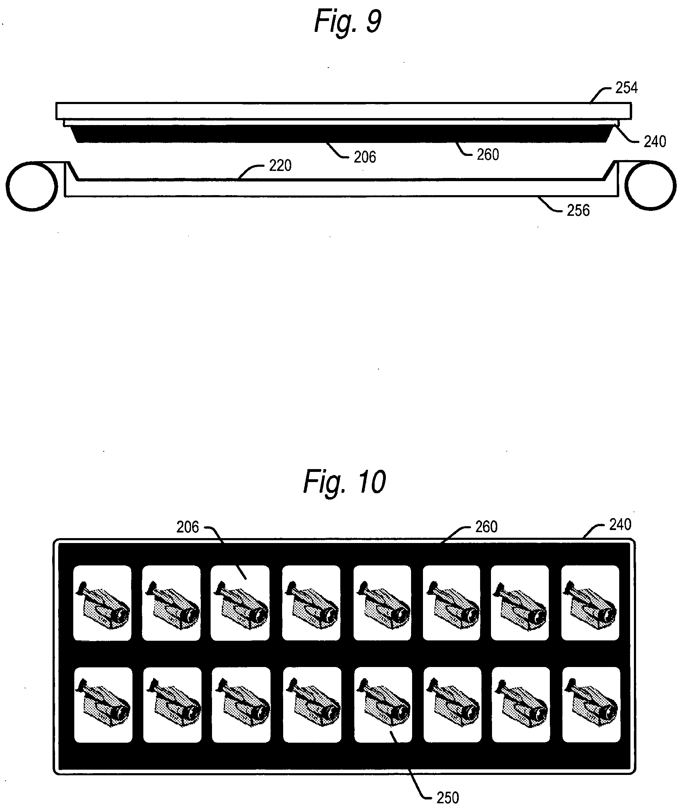

Thus, when the mold plates 254, 256 are separated from each other as shown in Fig. 9, the graphical content 206 remains in the surface of the molding compound 260, while the backing film 214 remains with the lower mold plate 256. A top view of the panel 240 is shown including the transferred graphical content 206 in Fig. 10. The cure and image transfer step 128 may take approximately 90 seconds, and may be performed at a temperature of 175°C.Where a roll of release media is used, after the above-described steps are performed, the roll may be advanced to position new graphical content 206 inside the mold plates, and the process repeated. Where precut sections of release media 210 are used, a handler removes the backing film 214, and a new section of pre-cut release media 210 is placed on the lower mold plate 256.

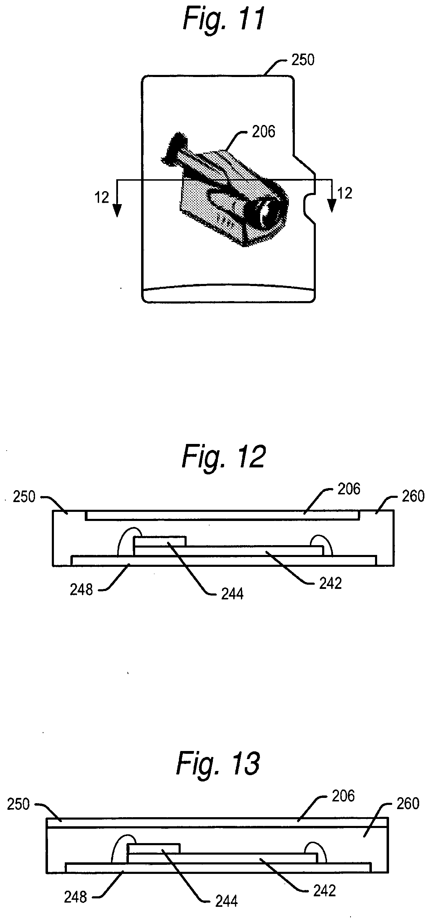

After application of the molding compound 260, the respective memory devices 250 on the panel 240 may be singulated in step 130, to form finished memory devices 250, shown for example in Fig. 11. Fig. 11 shows an example where memory device 250 is a MicroSD card. However, it is understood that memory device 250 may be any of various non-volatile memories operative to store information. Examples of memory devices include, but are not limited to, handheld, removable memory cards (such as SD or microSD cards), handheld universal serial bus ("USB") flash drives ("UFD"), embedded memory devices and removable or non-removable hard drives (such as solid-state drives). The technique of the present invention may further be used with to transfer an image onto devices used with a memory device 250, such as for example a memory card reader or adapter.

In further embodiments, the one or more memory die 242 and/or controller die 244 may themselves be encapsulated in a molding compound prior to being connected to the substrate 248. In such embodiments, the encapsulated memory die and/or controller die may themselves be considered a "memory device" as that term is used herein.

In the embodiments described above, the release media 210 is placed in the bottom mold plate 256 to provide an image on a top surface of a finished memory card 250. In further embodiments, release media 210 may be placed in the top mold plate 254 prior to the encapsulation step in addition to or instead of in the bottom mold plate 256 to provide graphical content on the bottom surface of the finished memory card 250.

Transfer of graphical content from a release media 210 onto memory device surface(s) according to the various embodiments may be performed while a panel 240 of memory devices is being encapsulated. This process saves time and processing steps over having to pre-treat a memory card surface to receive the image, and this process saves time and processing steps over having to separately encapsulate the memory devices 250, and then separately print an image on the memory devices 250.

In addition to saving time and process steps, providing graphical content 206 from a release media 210 on the top surface of a memory device 250 during the encapsulation step does not add to the overall thickness of the package. The release media is placed in the mold with the molten molding compound. As a result, the release media 210, and in particular the graphical content 206, gets embedded in the surface of the molding compound and does not add to the overall thickness of the memory device. That is, the thickness of the memory card formed by the addition of the molding compound would be the same with or without the added graphical content 206. This aspect is shown in the cross-sectional view of Fig. 12, which is taken through line 12-12 of Fig. 11. While Fig. 12 shows the graphical content 206 on only a portion of the surface of device 250, the graphical content 206 may cover the entire surface of device 250. Such an embodiment is shown in Fig. 13.

Some molding compounds include lubricants to allow easy removal of the finished molded panel from the mold plates. It is known that these lubricants can sometimes migrate to the surface of a memory card after encapsulation, which lubricants can degrade the adhesion of print on the surface of a memory card. This problem is solved in the present disclosure. As noted above, the image is embedded within the molding compound to prevent its removal even if lubricants do migrate to the surface. Moreover, the graphical content is buried as a whole within adhesive layer 220 of the release media 210, which cross links and forms a tight bond with the surface of the molding compound upon transfer.

In the embodiments described above, the graphical content is generally provided for artistic and/or identification purposes. However, the release media 210 may additionally include an electrically conductive layer which may be embedded within adhesive layer 220 and transferred onto the molding compound during the encapsulation steps 124, 128 as described above. The metal layer can serve as electromagnetic interference shielding and/or for thermal dissipation.

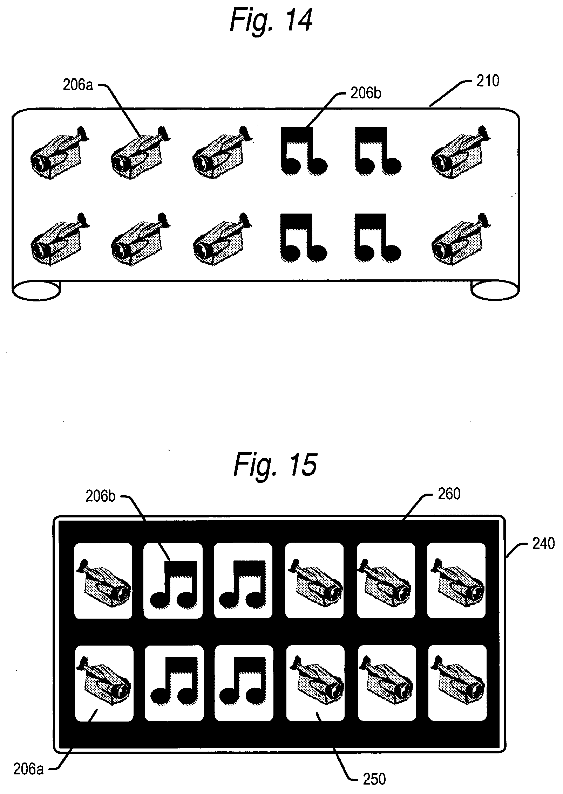

In the embodiments shown and described above, the images in the graphical content are the same for each memory device 250 formed on panel 240. However, in further embodiments, it is understood that different memory devices 250 on a signal panel 240 may receive different images. As one of a wide variety of examples, Figs. 13 and 14 show a release media including graphical content 206 including images 206a of cameras (perhaps to identify cards on which pictures are stored) and images 206b of musical notes (perhaps to identify cards on which music is stored). The image map allows the system controller 204 to associate specific and varied images with specific memory devices on a panel 240, and specific and varied images with specific panels 240 from a group of panels 240.

The foregoing detailed description of the invention has been presented for purposes of illustration and description. It is not intended to be exhaustive or to limit the invention to the precise form disclosed. Many modifications and variations are possible in light of the above teaching. The described embodiments were chosen in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. A method of providing graphical content on a memory device (250), comprising:
(a) positioning (110) a release media (210) within a mold (256) for encapsulating one or more memory devices, the release media including an adhesive layer (220), graphical content (206), a durable layer (218) on which the graphical content is formed, the graphical content being sandwiched between the adhesive layer and the durable layer, a backing film (214), and a release agent (216) provided between the backing film and durable layer;
(b) positioning (118) one or more memory devices (250) within the mold for encapsulating the one or more memory devices;
(c) providing (120) an amount of molding compound (260) within the mold for encapsulating the one or more memory devices, the molding compound provided in contact with the release media;
(d) encapsulating (124) the one or more memory devices in the molding compound using flow free thin compression molding; and
(e) heating (128) the release media during said step (d) of encapsulating the one or more memory devices, said heating of the release media melting the release agent (216) to separate the durable layer (218) from the backing film (214), and leaving the durable layer on the molding compound 260, and the adhesive layer and graphical content in the molding compound 260.

2. The method of claim 1, wherein the mold includes top and bottom mold plates (254, 256), said step (a) comprising positioning a release media on the bottom mold plate.

3. The method of claim 1, said step (b) comprising positioning the one or more memory devices on the top mold plate.

4. The method of claim 1 wherein said steps (d) and (e) comprise applying heat to the molding compound and release media to cure the molding compound and to cross link portions of the adhesive layer (220) to the molding compound (260).

5. The method of claim 1, wherein the graphical content is inkjet printed onto the release media used in said step (a).

6. The method of claim 1, wherein the graphical content includes electrically conductive portions that are transferred to the molding compound in said step (e).

7. The method of claim 1, wherein the graphical content (206) is embedded while the molding compound is in a molten phase.

8. The method of claim 1, wherein:
the release media (210) is a heat transfer foil; or
the release media (210) is an in mold roller foil.

9. The method of claim 1, wherein graphical content (206) is transferred from the release media concurrently with curing of the molding compound.

## Patentansprüche

1. Verfahren zum Bereitstellen von graphischem Inhalt auf einer Speichervorrichtung (250), umfassend:
(a) Anordnen (110) eines Freigabemediums (210) innerhalb einer Form (256) zum Einkapseln von ein oder mehreren Speichervorrichtungen, das Freigabemedium umfassend eine Haftschicht (220), graphischen Inhalt (206), eine dauerhafte Schicht (218) auf der der graphische Inhalt ausgebildet ist, wobei der graphische Inhalt zwischen der Haftschicht und der dauerhaften Schicht angeordnet ist, eine Trägerfolie (214) und ein Trennmittel (216) vorgesehen zwischen der Trägerfolie und der dauerhaften Schicht;
(b) Anordnen (118) von ein oder mehreren Speichervorrichtungen (250) in der Form zum Einkapseln der ein oder mehreren Speichervorrichtungen;
(c) Vorsehen (120) einer Menge an Formmasse (260) in der Form zum Einkapseln der ein oder mehreren Speichervorrichtungen, wobei die Formmasse in Kontakt mit dem Trennmittel angeordnet ist;
(d) Einkapseln (124) der ein oder mehreren Speichervorrichtungen in der Formmasse mittels frei fließendem dünnen Formpressen; und
(e) Erhitzen (128) des Freigabemediums während des Schrittes (d) des Einkapselns der ein oder mehreren Speichervorrichtungen, wobei das Erhitzen des Freigabemediums das Trennmittel (216) schmilzt, um die dauerhafte Schicht (218) von der Trägerfolie (214) zu trennen, und Zurücklassen der dauerhaften Schicht auf der Formmasse (260) und der Haftschicht und graphischen Inhalts in der Formmasse (260).

2. Verfahren nach Anspruch 1, wobei die Form obere und untere Formplatten (254, 256) aufweist, wobei der Schritt (a) Anordnen des Freigabemediums auf der unteren Formplatte umfasst.

3. Verfahren nach Anspruch 1, wobei der Schritt (b) Anordnen der ein oder mehreren Speichervorrichtungen auf der oberen Formplatte umfasst.

4. Verfahren nach Anspruch 1, wobei die Schritte (d) und (e) Anwenden von Wärme auf die Formmasse und das Freigabemedium umfasst, um die Formmasse auszuhärten und um Teile der Haftschicht (220) mit der Formmasse (260) zu vernetzen.

5. Verfahren nach Anspruch 1, wobei der graphische Inhalt in dem Schritt (a) auf das Freigabemedium Tintenstrahl gedruckt wird.

6. Verfahren nach Anspruch 1, wobei der graphische Inhalt elektrisch leitende Abschnitte aufweist, die in dem Schritt (e) auf die Formmasse übertragen werden.

7. Verfahren nach Anspruch 1, wobei der graphische Inhalt (206) eingebettet wird, während sich die Formmasse in einer Schmelzphase befindet.

8. Verfahren nach Anspruch 1, wobei
das Freigabemedium (210) eine Wärmetransferfolie ist; oder
das Freigabemedium (210) eine in die Form einzulegende Rollenfolie ist.

9. Verfahren nach Anspruch 1, wobei der graphische Inhalt (206) gleichzeitig zu dem Aushärten der Formmasse von dem Freigabemedium übertragen wird.

## Revendications

1. Procédé de mise en oeuvre d'un contenu graphique sur un dispositif de mémoire (250), comprenant les étapes consistant à :
(a) positionner (110) un support de libération (210) dans un moule (256) pour encapsuler un ou plus de dispositifs de mémoire, le support de libération comprenant une couche adhésive (220), un contenu graphique (206), une couche durable (218) sur laquelle le contenu graphique est formé, le contenu graphique étant pris en sandwich entre la couche adhésive et la couche durable, un film de support (214) et un agent de libération (216) disposé entre le film de support et la couche durable ;
(b) positionner (118) un ou plus de dispositifs de mémoire (250) dans le moule pour encapsuler les un ou plus de dispositifs de mémoire ;
(c) fournir (120) une quantité de composé de moulage (260) dans le moule pour encapsuler les un ou plus de dispositifs de mémoire, le composé de moulage étant placé en contact avec le support de libération ;
(d) encapsuler (124) les un ou plus de dispositifs de mémoire dans le composé de moulage en utilisant un moulage par compression mince sans écoulement ; et
(e) chauffer (128) le support de libération au cours de ladite étape (d) d'encapsulation des un ou plus de dispositifs de mémoire, ledit chauffage du support de libération faisant fondre l'agent de libération (216) pour séparer la couche durable (218) du film de support (214) et laissant la couche durable sur le composé de moulage (260) et la couche adhésive et le contenu graphique dans le composé de moulage (260).

2. Procédé selon la revendication 1, dans lequel le moule comprend des plaques de moulage supérieure et inférieure (254, 256), ladite étape (a) comprenant le positionnement d'un support de libération sur la plaque de moulage inférieure.

3. Procédé selon la revendication 1, ladite étape (b) comprenant le positionnement des un ou plus de dispositifs de mémoire sur la plaque de moulage supérieure.

4. Procédé selon la revendication 1, dans lequel lesdites étapes (d) et (e) comprennent l'application de chaleur au composé de moulage et au support de libération pour durcir le composé de moulage et réticuler des parties de la couche adhésive (220) sur le composé de moulage (260).

5. Procédé selon la revendication 1, dans lequel le contenu graphique est imprimé par jet d'encre sur le support de libération utilisé à ladite étape (a) .

6. Procédé selon la revendication 1, dans lequel le contenu graphique comprend des parties conductrices de l'électricité qui sont transférées au composé de moulage à ladite étape (e).

7. Procédé selon la revendication 1, dans lequel le contenu graphique (206) est noyé tandis que le composé de moulage se trouve en phase fondue.

8. Procédé selon la revendication 1, dans lequel :
le support de libération (210) est un film de transfert thermique ; ou
le support de libération (210) est un film de rouleau de moulage.

9. Procédé selon la revendication 1, dans lequel le contenu graphique (206) est transféré du support de libération simultanément avec le durcissement du composé de moulage.
